(19) Europäisches Patentamt
European Patent Office
Office européen des brevets

(11) EP 0 638 940 B1

(12) **EUROPÄISCHE PATENTSCHRIFT**

(45) Veröffentlichungstag und Bekanntmachung des Hinweises auf die Patenterteilung:
**15.11.2000 Patentblatt 2000/46**

(51) Int. Cl.[7]: **H01L 27/146**, H01L 31/112

(21) Anmeldenummer: **94112035.4**

(22) Anmeldetag: **02.08.1994**

(54) **Halbleiter-Photodetektor**

Semiconductor photodetector

Photodétecteur à semi-conducteur

(84) Benannte Vertragsstaaten:
**DE FR GB IT**

(30) Priorität: **11.08.1993 DE 4326754**

(43) Veröffentlichungstag der Anmeldung:
**15.02.1995 Patentblatt 1995/07**

(73) Patentinhaber:
**DaimlerChrysler AG**
**70567 Stuttgart (DE)**

(72) Erfinder:
• **Brugger, Hans, Dr.**
**D-89250 Senden (DE)**
• **Meiners, Ulf**
**D-89250 Senden (DE)**
• **Schlosser, Ewald**
**D-89250 Senden (DE)**

(74) Vertreter:
**Fröhling, Werner Otto, Dr. et al**
**DaimlerChrysler AG,**
**Intellectual Property Management,**
**Sedanstr. 10/Gebäude 17**
**89077 Ulm (DE)**

(56) Entgegenhaltungen:
**US-A- 3 366 802**     **US-A- 4 326 210**
**US-A- 4 733 286**

• **APPLIED PHYSICS LETTERS, Bd. 61, Nr. 9, 31.August 1992, Seiten 1048-1050, XP000294449 WIECK A D ET AL: "HIGH TRANSCONDUCTANCE IN-PLANE-GATED TRANSISTORS"**
• **APPLIED PHYSICS LETTERS, Bd. 64, Nr. 5, 31.Januar 1994, Seiten 592-594, XP000422911 BAUMGARTNER P ET AL: "FABRICATION OF IN-PLANE-GATE TRANSISTOR STRUCTURES BY FOCUSED LASER BEAM-INDUCED ZN DOPING OF MODULATION-DOPED GAAS/ALGAAS QUANTUM WELLS"**
• **APPLIED PHYSICS LETTERS, Bd. 57, Nr. 25, 17.Dezember 1990, Seiten 2695-2697, XP000176416 NIEDER J ET AL: "ONE-DIMENSIONAL LATERAL-FIELD-EFFECT TRANSISTOR WITH TRENCH GATE-CHANNEL INSULATION"**
• **APPLIED PHYSICS LETTERS, Bd. 61, Nr. 14, 5.Oktober 1992, Seiten 1667-1669, XP000307508 HIRAYAMA Y: "N- AND P-TYPE IN-PLANE GATED FIELD EFFECT TRANSISTORS DIRECTLY WRITTEN ON A SEMI-INSULATING GAAS SUBSTRATE"**

**Beschreibung**

Die Erfindung betrifft einen Halbleiter-Photodetektor. Photodetektoren sollen im allgemeinen möglichst empfindlich und über einen weiten Dynamikbereich der einfallenden Lichtleistung einsetzbar sein. Um auch bei kleiner Lichtleistung ein auswertbares Signal zu erhalten, sind häufig photoempfindliche Elemente mit einer nachgeschalteten Verstärkeranordnung kombiniert, die zur Bewältigung des großen Dynamikbereichs eine nichtlineare Verstärkungskennlinie aufweist.

Es sind aber auch bereits Photodetektoren mit interner Verstärkung z.B. in Form von Lawinenphotodioden oder Phototransistoren bekannt.

Lawinenphotodioden für einen weiten Wellenlängenbereich sind z.B. beschrieben in D. Law et al.: "Alloy heterostructure high speed avalanche photodiodes", Journal of Quantum Electronics, QE15, 549 (1979). Bipolar- bzw. Heterobipolar-Phototransistoren, sind z.B. beschrieben in S. Chandrasekhar et al.: "High speed monolithic P-I-N/HBT and HPT/HBT photoreceivers implemented with simple phototransistor structures", Proc. ECOC-Conference 1993, Berlin, Germany. Diese Lösungen weisen aber eine Reihe von Nachteilen auf. Lawinendioden sind zwar sehr empfindlich, benötigen aber zur Erhöhung der Dynamik zusätzliche elektronische Maßnahmen. Demgegenüber sind die Bipolar-Phototransistoren gerade bei kleinen Lichtleistungen unempfindlich. Die Empfindlichkeiten von beiden Detektortypen liegen typischerweise im Bereich zwischen 10 A/W und 1 000 A/W.

Aus der US-A-3 366 802 ist eine als Photodetektor eingesetzte Feldeffekttransistor-Anordnung bekannt, bei welcher in ein p-dotiertes Substrat eine n-dotierte Wanne eingebaut ist, in welcher wiederum stärker n-dotierte Source- und Drain-Anschlußbereiche realisiert sind. Zusätzlich kann zwischen Source- und Drain-Anschluß ein Gate-Bereich vorgesehen sein. Die pn-Übergänge bilden Raumladungszonenaus, welche die Source-Drain-Verbindung einschnüren. Bei Lichteinfall wird die Weite der Raumladungszonen reduziert und dadurch die Leitfähigkeit des Bauelements erhöht.

Die US-A-4 733 286 beschreibt einen Photodetektor, der aus einer auf einem Substrat epitaktisch aufgewachsenen n-dotierten Schicht hergestellt wird. Dabei werden die Source- und Drainzonen durch Eindiffusion einer n-Dotierung erzeugt sowie eine ebenfalls durch Eindiffusion erzeugte p-Gate Zone zwischen Source- und Drain-Anschlüssen. Das p-Gate wird zur Steuerung des Source-Drain-Stromes als Maß für die Lichteinwirkung im Bauteil verwendet.

Die US-A-4 326 210 beschreibt ein photoempfindliches Feldeffekt-Bauelement, welches an der Oberfläche einer gering leitenden Schicht mindestens zwei Gate-Bereiche und von diesen umschlossen einen Source-Anschluß aufweist, dem auf der gegenüberliegenden Substratrückseite ein Drain-Anschluß zugeordnet ist. Ein senkrecht zur Bauelementoberfläche verlaufender Stromkanal wird durch Raumladungszonen, die sich an den pn-Übergängen der Gate bereiche ausbilden abgeschnürt. Bei Lichteinfall werden die Raumladungszonen reduziert und ein zwischen Source und Drain fließender Strom wird als elektrisches Signal ausgegeben.

Aufgabe der vorliegenden Erfindung ist es daher, einen Halbleiter-Photodetektor anzugeben, der bei einfachem Aufbau einen weiten Dynamikbereich und hohe Empfindlichkeit aufweist, sowie ein Verfahren zur Herstellung solcher Detektoren.

Der erfindungsgemäße Detektor ist im Patentanspruch 1 beschrieben. Die Unteransprüche 2 bis 11 enthalten vorteilhafte Ausgestaltungen und Weiterbildungen der Erfindung. Den Ansprüchen 12 bis 18 sind Verfahren zur Herstellung eines solchen Photodetektors entnehmbar.

Der erfindungsgemäße Photodetektor ist einfach aufgebaut und weist insbesondere bei kleinen Lichtleistungen eine sehr hohe Empfindlichkeit auf.

Bei höheren Lichtleistungen besteht ein logarithmischer Zusammenhang zwischen dem Ausgangsstrom und der Lichtleistung, wodurch ein hoher Dynamikbereich erreicht wird. Durch Einsatz unterschiedlicher Halbleiterschichtstrukturen läßt sich die Empfindlichkeit in einem Wellenlängenbereich von etwa 600 nm (sichtbarer Spektralbereich) bis ca. 2 μm (infraroter Spektralbereich) einstellen. Die Detektoren können in Form von Zeilen- und Flächen-Arrays integriert werden.

Die Erfindung ist nachfolgend anhand von bevorzugten Ausführungsbeispielen noch eingehend veranschaulicht.

Fig. 1: Schematische Darstellung eines Photodetektors.

Fig. 2: Querschnittsdarstellung senkrecht zum Kanalbereich des Detektors von Fig. 1.

Fig. 3: Leitungsband-Potentialverlauf senkrecht zum Kanalbereich des Detektors von Fig. 1.

Fig. 4: Ergebnisse einer rechnerischen Abschätzung zur erwarteten Photoempfindlichkeit und zur Ausgangsstromänderung des Photodetektors von Fig. 1.

Fig. 5: Schematische Darstellung eines vertikalen, epitaktisch hergestellten Schichtaufbaus für den Photodetektor

Fig. 6: Leitungs- und Valenzband-Potentialverlauf senkrecht durch die vertikale Halbleiter heterostruktur-Schichtenfolge entlang der Verbindungslinie A-A' von Fig. 5

Fig. 7:     Laterale Kontaktanordnung eines einzelnen Photodetektorelements

Fig. 8:     Leitungs- und Valenzband-Potentialverlauf quer zum Kanalbereich entlang der Verbindungslinie A''-A''' in Fig. 7.

Fig. 9:     Darstellung eines Photodetektors in Form einer Doppelzeilenanordnung (Liniendetektor)

Fig. 10:    Detektorelemente mit erhöhtem Füllfaktor

Fig. 11:    Strom-/Spannungstrennlinien des Photodetektors bei verschiedenen Lichtleistungen

Fig. 12:    Lichtleistungsabhängiger Strom- und Empfindlichkeitsverlauf eines Flächen-Array Photodetektors.

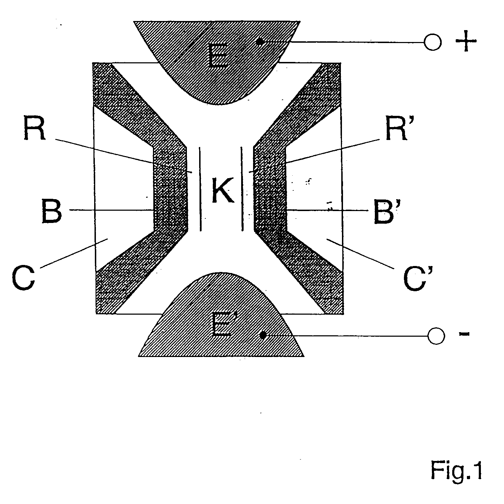

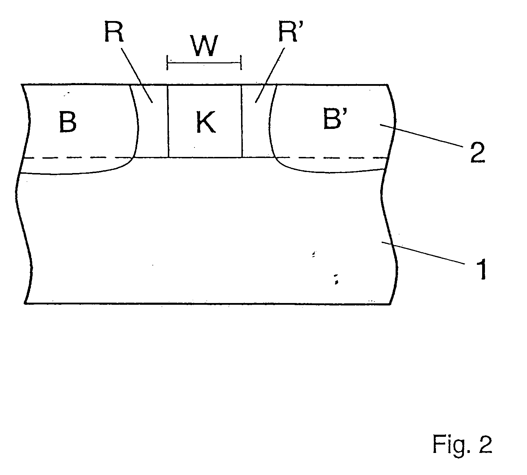

Fig. 1 zeigt schematisch die Struktur eines Photodetektors in planarer Ausführung.
Auf der Halbleiteroberfläche befinden sich stromtreibende Elektroden (E, E') und senkrecht zu der Oberfläche sichvollständig durch eine leitende Schicht erstreckende Barrierenbereiche (B, B'), die einen Stromkanal (K) in der leitenden Schicht definieren. In Fig. 2 ist ein Querschnitt durch den Kanalbereich einer Anordnung nach Fig. 1 mit z.B. einer n-leitenden Schicht zwischen den beiden Barrierengebieten (B, B') gezeigt. Die Halbleiterschichtstruktur besteht im einfachsten vorteilhaften Fall aus einer, z.B. epitaktisch hergestellten, leitenden Schicht (2) auf einem semi-isolierenden Substrat (1) mit in der leitenden Schicht hergestellten Potential-Barrierebereichen. Anstelle der einen leitenden Schicht kann auch eine Schichtenfolge auf dem Substrat vorgesehen sein, in welcher u.U. nicht alle Schichten leitend sind. Durch die laterale Strukturierung des Bauelements bleibt die Tiefe der lichtabsorbierenden Raumladungszonen weitgehend unabhängig von der aktuellen Beleuchtungsstärke. Eine erfindungsgemäße Ausführungsform sieht die Ausführung der leitenden Schicht als vertikalen Quantumwell vor, bei welcher trotz geringer Schichtdicke eine gute Photoempfindlichkeit gegeben ist.

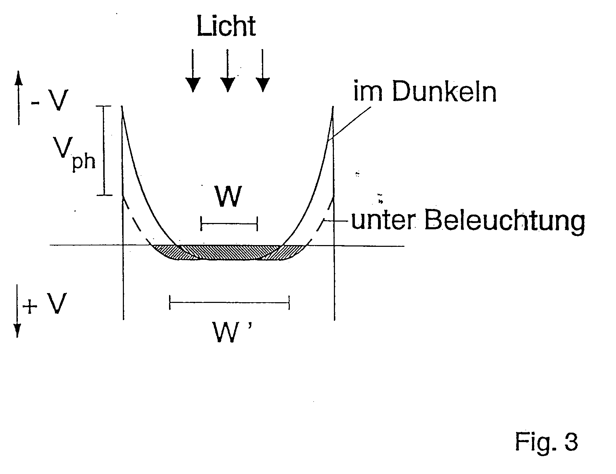

Die Fig. 3 veranschaulicht die Wirkungsweise des Photodetektors anhand eines Bänderdiagramms für einen Kanal aus n-leitendem Halbleitermaterial.

Die Potential-Barrierenbereiche bewirken Bandverbiegungen im Kanalbereich K, die Raumladungszonen R, R' an den Kanalrandbereichen hervorrufen und damit eine effektive Kanalbreite w für den Stromfluß zwischen E und E' festlegen (Fig. 1, 2). Die Raumladungszonen sind an freien Ladungsträgern verarmt. In den Kanalbereich einfallendes und absorbiertes Licht mit einer Energie oberhalb der Energiebandlücke des Halbleitermaterials erzeugt Elektronen-Loch-Paare, die die Potentialbarrieren bzw. Raumladungszonen abbauen und dadurch zu einer Erhöhung der effektiven Kanalbreite auf W'führen. Die Zunahme des Kanalstroms (bei gleichbleibender Spannung zwischen E und E' oder bei Sättigung des Kanalstroms) liegt weit über dem den photoinduzierten freien Ladungsträgern entsprechenden Strom. Der Photodetektor kann daher auch als lichtempfindliches Element mit interner Verstärkung betrachtet werden, bei welchem der Abbau der Potentialbarriere die Stromänderung im Kanal steuert. Betrachtet man den Abbau der Potentialbarriere als Erzeugung einer positiven Photospannung Vph, so kann die Steuerwirkung durch eine Steilheit gm des Detektors beschrieben werden, die die Änderung des Kanalstroms als Funktion dieser Spannung angibt.

Die Empfindlichkeit der Anordnung läßt sich in einfacher Weise berechnen. Die erzeugte Photospannung ist gegeben durch:

$$V_{ph} = (nkT/e) \ln[(eP_{abs}/h\nu)/I0 + 1] \qquad (1)$$

Die dadurch verursachte Erhöhung des Ausgangsstroms berechnet sich nach:

$$\Delta I_{EE'} = V_{ph}\, g_m \qquad (2)$$

Daraus ergibt sich die Empfindlichkeit des Photodetektors:

$$S = \Delta I_{EE'}/P_{abs} \qquad (3)$$

mit

| | |
|---|---|
| $V_{ph}$ (V) | Photospannung |
| $P_{abs}$ (W) | Absorbierte Lichtleistung |
| $h\nu$ (J) | Photonenenergie |
| I0 (A) | Sättigüngssperrstrom zwischen Kanal- und Barrierenbereich |
| $\Delta I_{EE'}$ (A) | Änderung des Kanalstroms durch Lichteinstrahlung |
| $g_m$ (A/V) | Steilheit |
| S (A/W) | Detektorempfindlichkeit |
| n | Idealitätsfaktor der Diodenkennlinien |
| k (J/K) | Boltzmannkonstante |
| T (K) | Absolute Temperatur |
| e (As) | Elementarladung |

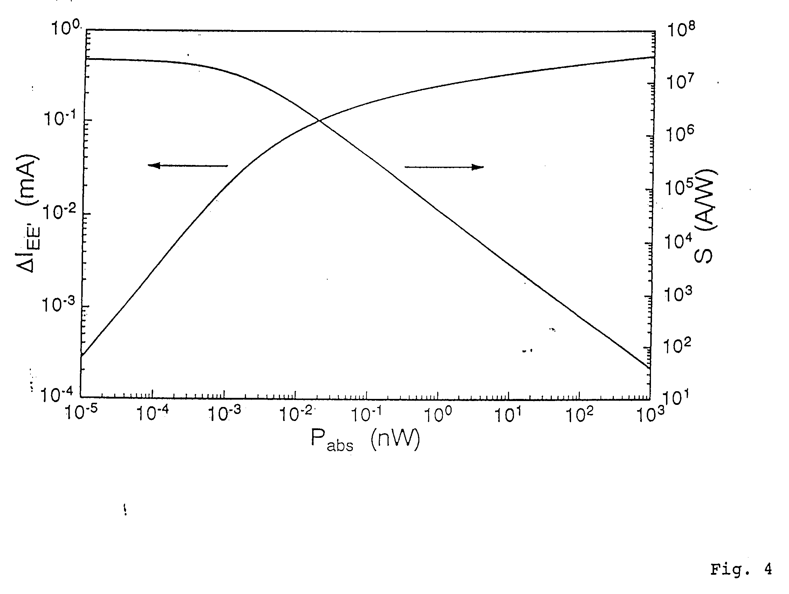

Der so berechnete Ausgangsstrom und die Empfindlichkeit sind in Fig. 4 dargestellt. Hierbei wurden exemplarisch die folgenden Werte angenommen: GaAs-Material ( $h\nu/e$ = 1.43 V ), kT/e = 0,025 V , gm = 1 mA/V , I0 = 1 pA , n = 1,5. Mit diesen Daten soll lediglich eine Abschätzung der zu erwartenden Eigenschaften durchgeführt werden. Aus Fig. 4 erkennt man, daß bei kleinen Lichtleistungen die Empfindlichkeit konstant ist und Werte von über $10^6$ A/W erreicht werden.

Bei größeren Leistungen nimmt die Empfindlichkeit ab und der Ausgangsstrom ist eine logarithmische Funktion der Lichtleistung. Diese Charakteristik ist wesentlich für den großen Dynamikbereich des Detektors. Als Detektorsignal können der Kanalstrom und/oder die am Stromkanal abfallende Spannung sowie daraus abgeleitete Größen ausgewertet werden.

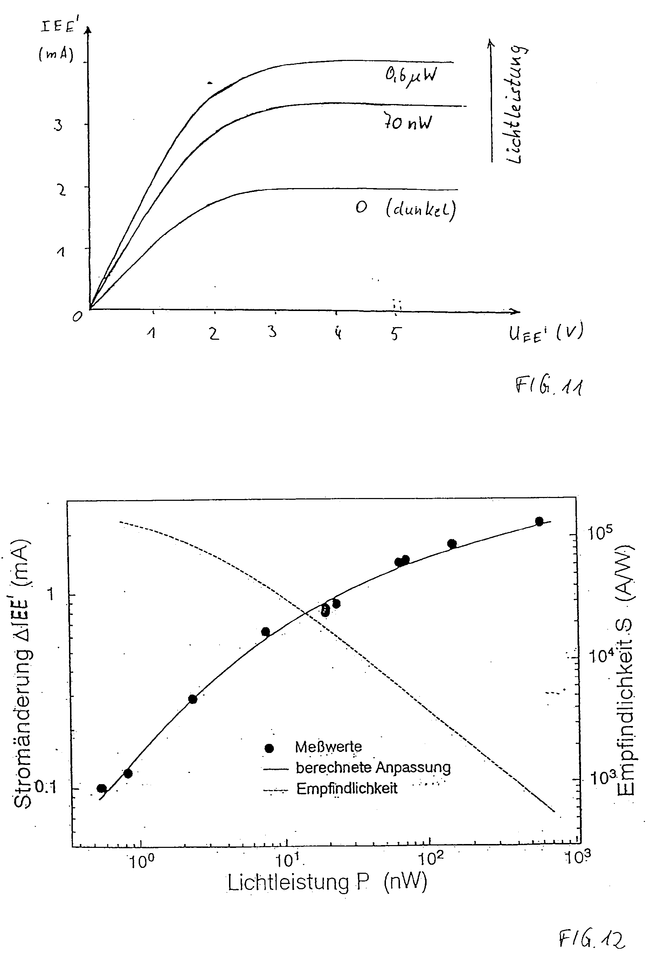

Hier ist es besonders vorteilhaft, daß die Strom-/Spannungs-Kennlinien des Detektors ein sättigendes Verhalten zeigen. Dies ist in Fig. 11 anhand von experimentellen Messungen an einem erfindungsgemäßen Ausführungsbeispiel gezeigt. Oberhalb einer Spannung von typischerweise 1V bis 2V sättigt der Kanalstrom. Betreibt man den Photodetektor im Sättigungsbereich, dann hängt das Detektorsignal nicht mehr von der Betriebsspannung zwischen E und E'ab und ist dann wie in Fig. 11 ersichtlich nur noch von der eingestrahlten Lichtleistung abhängig. Als Detektorausgangssignal kann dann der Detektorstrom und/oder die an einen Serienvorwiderstand abfallende Spannung ausgewertet werden.

Der Abbau der Potentialbarriere bei Lichteinfall kann nicht nur analog zur Erzeugung einer Photospannung, sondern auch zum Anlegen einer äußeren Spannung zwischen den Barrierebereichen und dem Kanal betrachtet werden. Eine Weiterbildung der Erfindung sieht daher zwei weitere Elektroden C, C' seitlich des Kanals vor, über die durch Anlegen einer Spannung die Empfindlichkeit des Detektors gesteuert und/oder das Detektorsignal moduliert werden kann. Durch den erfindungsgemäßen Aufbau des Detektorelements ist auch durch solche zusätzlichen Elektroden die Lichtempfindlichkeit in keiner Weise beeinträchtigt und die Anordnung unverändert planar ausführbar.

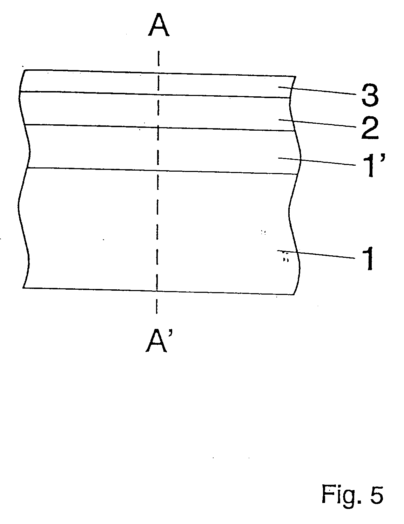

In den folgenden Abschnitten wird an Hand eines Ausführungsbeispiels mit experimentellen Meßergebnissen gezeigt, wie die erfindungsgemäße Anordnung in vorteilhafter Weise realisiert werden kann. Dies betrifft insbesondere die Auswahl geeigneter Materialkombinationen sowie das Verfahren zur Erzeugung der Steuerbereiche. Dabei sind besonders vorteilhafte Ausführungsformen gemäß der Erfindung unter Bezugnahme auf die schematischen Darstellungen und die Meßkurven in den Abbildungen Fig. 5 bis Fig. 12 erläutert.

Der vertikale Schichtaufbau eines vorteilhaft ausgeführten Halbleiterdetektors auf der Basis einer III/V-Materialkombination ist in Fig. 5 dargestellt. Als Substrat wird eine semi-isolierende Galliumarsenid (GaAs) Halbleiterscheibe 1 verwendet. Mit Hilfe eines epitaktischen Kristallwachstumsverfahrens, z.B. Molekularstrahlepitaxie-Technik (MBE), wird direkt auf das Substrat 1 eine üblicherweise standardmäßig verwendete ca. 1 μm dicke, undotierte GaAs-Pufferschicht 1', die vorteilhafterweise noch ein kurzperiodiges AlAs (2 nm)/GaAs (2 nm) Übergitter enthält, aufgebracht. Danach folgt eine pseudomorphe (d.h. elastisch verspannte) Potentialtopfschicht aus z.B.

In(20%)Ga(80%)As mit einer vorzugsweisen Schichtdicke im Bereich der elastischen Verspannung zwischen 10 nm und 50 nm und einer Silizium-Dotierkonzentration im Bereich von über $10^{18}$ cm$^{-3}$. Dies resultiert in einer effektiven Hall-Trägerdichte von ca. $2 \times 10^{12}$ cm$^{-2}$. Vorzugsweise wird die Dotierung in Form eines dünnen Dotierspikes innerhalb von weniger als 10 nm eingebaut. Eine abschließende Deckschicht 3 besteht aus 40 nm dickem GaAs-Material, das mit ca. $3 \times 10^{17}$ cm$^{-3}$ dotiert ist. Die oberflächennahen, ca. 10 nm dicken Bereiche werden zur Realisierung von niederohmigen Kontakten sehr hoch dotiert, vorzugsweise im Bereich von $3 \times 10^{18}$ cm$^{-3}$ bis $1 \times 10^{19}$ cm$^{-3}$. Durch Verwendung von geringeren In-Gehalten lassen sich entsprechend dickere Schichten realisieren.

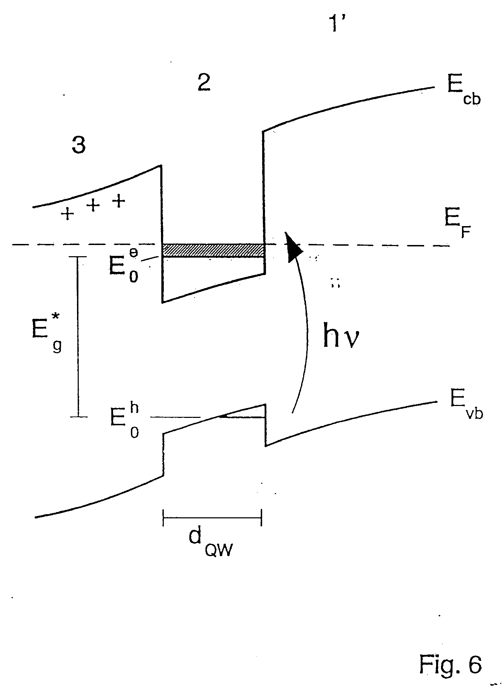

Da die Bandlückenenergie von InGaAs-Material kleiner ist als von GaAs-Material entsteht eine sog. Potentialtopfstruktur (auch Quantenwell QW genannt) mit der Breite dQW, wie in Fig. 6 schematisch dargestellt. Dadurch ist die elektronische Leitfähigkeit auf diesen QW-Bereich von beispielsweise 20 nm begrenzt. Der Dotierungsverlauf in der Deckschicht (3) ist vorzugsweise so gewählt, daß aufgrund der natürlichen Oberflächenbandverbiegung keine elektrische Parallelleitfähigkeit oberhalb des Potentialtopfs stattfindet. Optische Strahlung wird ab einer Wellenlänge $\lambda < \lambda c = hc/(Eg^* + EF - E0e)$ absorbiert, wobei die effektive Energiebandlücke (Eg*) durch Quantisierungseffekte bestimmt ist und durch den Abstand des ersten Elektronensubbands E0e und des ersten Lochsubbands E0h, sowie die Fermi-Energie ($E_F$ - E0e) festgelegt ist. Durch die Materialzusammensetzung und die Potentialtopfbreite dQW läßt sich die cut-off Wellenlänge $\lambda c$ über einen weiten Bereich einstellen. Diese Anordnung erlaubt eine hohe Verstärkung und eine selektive Absorption des Lichts im leitfähigen Bereich. Damit sind besonders hohe Detektorempfindlichkeiten zu erwarten. Außerdem wird es dadurch möglich, von der Rückseite einzustrahlen, wie es etwa für upside-down montierte Aufbauten von Vorteil ist.

Eine weitere vorteilhafte Erhöhung der Empfindlichkeit des Detektors wird durch den Einbau von mehreren InGaAs-Potentialtopfschichten 2 erreicht, die durch z.B. 30 nm dicke und $10^{17}$ cm$^{-3}$ dotierte (Al)GaAs Barrierenschichten voneinander separiert sind.

Für den Aufbau des Halbleitermaterials, das vorzugsweise als eine vertikale Schichtfolge auf einem Substrat realisiert ist, sehen bevorzugte Ausführungen alternativ oder in Kombination insbesondere vor, daß

- die leitfähigen Bereiche aus einer oder mehreren, dotierten Potentialtopfstrukturen bestehen
- die leitfhäigen Bereiche aus einer oder mehreren, modulationsdotierten Potentialtopfstrukturen bestehen
- die leitfhäigen Bereiche aus einer Kombination aus einer oder mehreren dotierten oder modulationsdotierten Potentialtopfstrukturen bestehen

- die leitfähigen Bereiche direkt an der Oberfläche liegen bzw. bis zur Oberfläche reichen
- die leitfhäigen Bereich durch eine Deckschicht abgedeckt sind und unterhalb der Oberfläche angeordnet sind.

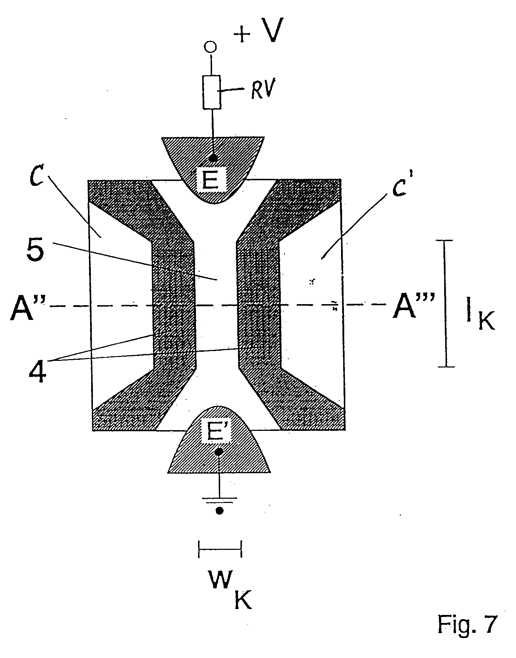

Eine vorteilhafte, laterale Auslegung der Bauelementgeometrie ist in Fig. 7 dargestellt. Eine Detektorelement wird durch einen, z.B. quadratischen Bereich definiert, der durch eine Mesaätzung bzw. durch eine Isolationsimplantation in den außenliegenden Gebieten, erzeugt wird. Typische Abmessungen der Mesakantenlänge liegen im Bereich von 5 μm bis 10 μm. Aus dem ursprünglich ganzflächig zusammenhängenden Gebiet wird durch die Erzeugung von Barrierenbereichen 4 ein schmaler Stromkanal 5 hergestellt. Die elektrischen Anschlüße werden durch ohmsche Kontaktbereiche E, E', z.B. legierte Ge/Ni/Au-Metallisierungen, realisiert. Die Barrierengeometrie wird so ausgelegt, daß z.B. trapezförmige Barrieren (siehe Fig. 7) einen Kanalbereich 5 mit einer Länge lk im Bereich von z.B. 0.1 μm bis 5 μm ausgebildet wird. Vorzugsweise ist die Länge des Kanals größer als dessen laterale Weite wk. Die nominelle Kanalbreite wk liegt typischerweise im Bereich von 0.1 μm und 3 μm. Die Dicke der Potentialbarrieren ist im Bereich von 0.1 μm bis 2 μm. Mit RV ist ein mit dem Stromkanal in Reihe geschalteter Vorwiderstand bezeichnet.

Alternativ zum trapezförmigen Kanalverlauf sind selbstverständlich auch andere, insbesondere konisch zulaufende Formen bzw. dreiecksförmig zulaufende Barrierengebiete möglich. Die Kanalform kann u.a. benutzt werden, um im Einzelfall die Detektorempfindlichkeit zu optimieren.

Die Barrierenbereiche bestehen beispielsweise aus hochisolierenden Gebieten. Die Herstellung erfolgt über eine selektive Implantation durch z.B. Protonen oder Bor-Ionen. Hierzu wird die Halbleiterscheibe mit Fotolack und/oder einer dielektrischen Schicht belegt und Fensteröffnungen erzeugt, die mit photolithographischen bzw. elektronenstrahllithographischen Methoden und anschließendem naß- bzw. plasmachemischen Ätzverfahren erzeugt werden. Die so strukturierte Fotolack- bzw. dielektrische Schicht dient als Maske für den Implantationsschritt. Alternativ kann auch ein fokussierter Ionenstrahl ausgenutzt werden, der die selektive Implantation direkt, d.h. ohne Maskenstrukturierung, in der Halbleiterscheibe erzeugt. Die beim Implantationsprozeß verursachte Kristallschädigung erzeugt eine Isolationswirkung und führt zu einer energetischen Barriere, die typischerweise im Bereich ≥ 0.7 eV liegt.

Alternativ können Sauerstoff-Ionen verwendet werden, die tiefe elektronische Akzeptorzustände in (Al,In)GaAs-Material erzeugen. Die Aktivierung erfolgt durch einen entsprechenden Ausheilschritt bei hohen Temperaturen von über 600°C. Mit diesem Verfahren werden ebenfalls Potentialbarrieren erzeugt, jedoch ohne schädigungsinduzierte Kristalldefekte, was - je nach Anwendungsfall - ein wesentlicher Vorteil sein kann.

Alternativ können durch Verwendung von Dotier-Ionen des anderen Ladungsträgertyps als in der leitfähigen Schicht, und anschließendem Ausheilen Potentialbarrieren erzeugt werden, z.B. für p-leitende Potentialbereiche durch Kohlenstoff-, Beryllium-, Magnesium-, Gallium-Ionen, etc. und für n-leitende Bereiche durch Silizium-, Zinn-Ionen, etc. Dadurch wird eine maximale Barrierenhöhe im Bereich der Bandlückenenergie von > 1 eV in (In)GaAs-Material erzeugt und schädigungsinduzierte Kristalldefekte ebenfalls vermieden.

Alternativ können auch nur sehr flache Implantationsprofile verwendet werden, die nicht bis zur leitfähigen Schicht 2 reichen. Dadurch werden Verarmungszonen erzeugt, die sich in vertikaler Richtung in das leitfähige Gebiet 2 ausdehnen und somit eine laterale Energiebarriere für parallelen Transport in der leitfähigen Schicht 2 darstellen.

Alternativ lassen sich zur Herstellung geringster I0-Werte Vakuumbereiche bzw. Luftspalte als elektronische Barrieren benutzen, die durch eine selektive Grubenätzung realisiert werden, wie sie heute in der Halbleitertechnologie standardmäßig in Form von naßchemischen bzw. plasmachemischen Ätzprozessen hergestellt werden.

Alternativ lassen sich Barrieren durch Dotierung mittels Diffusionsverfahren und lokale, thermische Durchmischung erzeugen.

Alternativ lassen sich die Barrierenstrukturen dadurch erzeugen, daß man vor dem epitaktischen Wachstum der leitfähigen Schicht 2 Isolationsstrukturen in der Substratscheibe erzeugt durch Einsatz der o.g., selektiven Implantationstechniken und die detektorspezifischen Schichten 2 und 3 durch einen epitaktischen Überwachstumsprozeß herstellt. Dadurch werden Verarmungszonen ausgebildet, die in vertikaler Richtung Potentialbarrieren für den parallelen Transport in der leitfähigen Schicht bewirken. Dadurch werden ebenfalls defektfreie Barrierengebiete im Bereich der leitfähigen Schicht 2 erzeugt.

Alternativ lassen sich Detektorstrukturen dadurch herstellen, daß die leitfähigen Gebiete direkt durch selektive Implantationstechniken bzw. fokussierte Implantation von Dotieratomen in ein semi-isolierendes Substrat erzeugt werden. Die Potentialbarrieren werden dann durch das semiisolierende Substratmaterial gebildet.

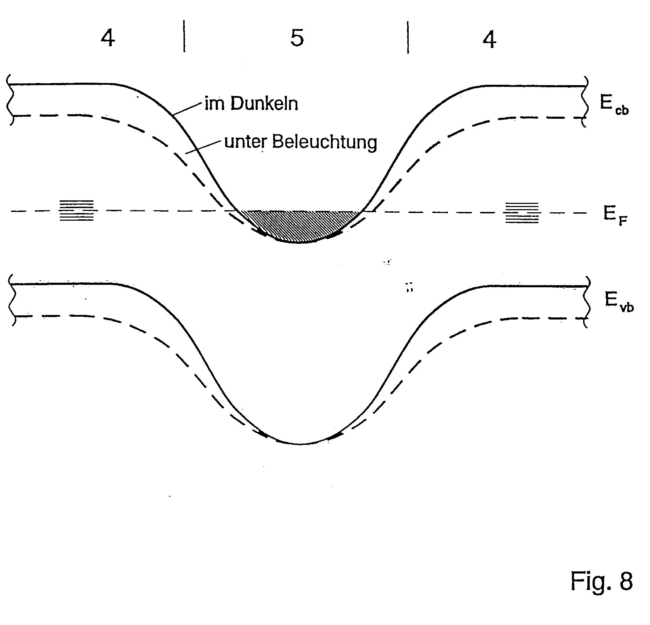

In Fig. 8 ist der Leitungs- und Valenzbandverlauf für den im Vorschlag ausgeführten, n-leitenden Detektor mit beidseitiger, symmetrischer Potentialbarrierenanordnung senkrecht zum Kanalbereich entlang des Schnitts A''-A''' gezeigt. Durch die Beleuchtung im Kanalbereich 5 werden die Raumladungszonen R, R' abgebaut. Dies hat eine Aufweitung der effektiven Kanalbreite von w auf w' zur Folge und führt zu einer sehr effektiven Zunahme des Stroms.

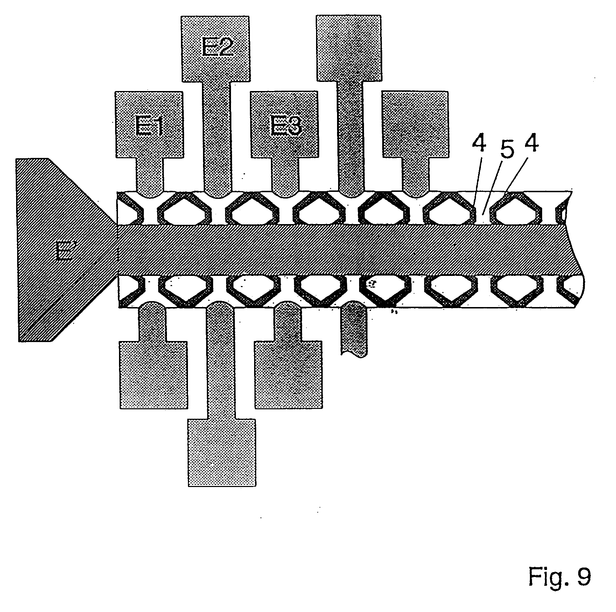

In Fig. 9 ist eine Darstellung eines Zeilendetektors mit zwei Linien von aneineinandergereihten Detektorelementen gezeigt. Die elektrische Masseverbindung wird über eine gemeinsame Elektrode E' hergestellt. Die selektive Auslesung der einzelnen Zellen geschieht über separate Elektroden (E1, E2, ...). Damit ist ein Pixelabstand in Zeilenrichtung im Bereich von weniger als 10 µm realisierbar, selbst wenn die Zuleitungsleiterbahnen alle parallel nebeneinander in einer Ein-Lagen-Verdrahtungstechnik weggeführt werden. Durch komplexere Verdrahtungsschemata, wie sie heute Stand der Technik sind, lassen sich höhere Pixeldichten realsieren.

Eine matrixförmige Anordnung von Einzeldetektoren, z.B. durch eine Kaskadierung der in Fig. 9 vorgestellten Detektorzeilen ermöglicht die Realisierung eines Flächen-Array-Detektors für Kameraanwendungen bzw. für höchst präzise Mikropositionierung im sub-µm Bereich. Letzteres wird dadurch ermöglicht, daß der Detektor nur im Bereich der Raumladungszonen ein Ansprechverhalten zeigt.

Wie aus Fig. 3 und Fig. 8 entnehmbar ist, ist die relative Stromänderung bei Beleuchtung gegenüber dem Dunkelzustand auch stark abhängig von dem Verhältnis der Breite der Raumladungszonen R, R' zur anfänglichen effektiven Kanalbreite w, was durch einen Flächenfüllfaktor ausgedrückt werden kann.

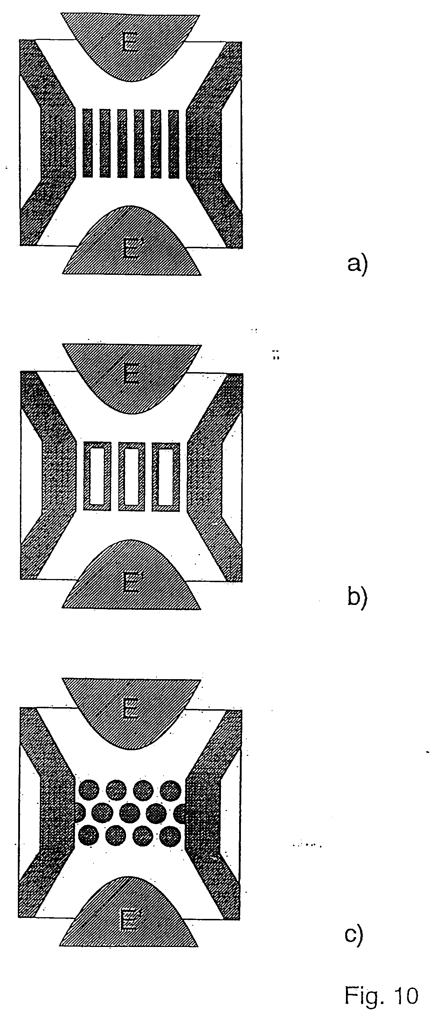

Eine Steigerung der Empfindlichkeit eines Pixels kann deshalb dadurch erreicht werden, daß eine Einzelzelle nicht nur durch einen einzigen, photoempfindlichen Stromkanal gebildet wird, sondern aus einer Serie von parallelen Teilkanälen TK, mit gemeinsamen Elektroden E, E'. Vorteilhafte Ausführungsformen zeigt die FIG. 10. Mehrere, örtlich und elektrisch parallel zueinander verlaufende Teilkanäle TK werden durch Potentialbarrierenbereiche in Form von Rechtecken, Punkten usw. realisiert, die von den Teilkanälen inselartig isoliert umschlossen sind. Mit dieser Anordnung wird der Füllfaktor, d.h. die photosensitive Fläche (effektive Raumladungszonenbereiche) relativ zur schaltungstechnisch benötigten Bauelementfläche vervielfacht. Kaskadiert man derartige Einzelzellen entsprechend den o.g. Ausführungsbeispielen zur Realisierung von Zeilen- und Flächendetektoren, so wird der Empfindlichkeitsvorteil direkt übertragen, ohne daß der Geamtflächenbedarf erhöht wird.

In Fig. 11 ist eine gemessene Detektorcharakteristik mit dem im Ausführungsbeispiel dargestellten Schichtaufbau mittels einer leitfähigen InGaAs-Absorberschicht dargestellt. Die Meßkurven wurden bei Raumtemperatur an einem Flächen-Array-Photodetektor mit 48 parallel kontaktierten Detektorelementen, die jeweils eine Mesafläche von 144 µm² aufweisen, aufgenommen. Jedes Detektorelement enthält jeweils nur einen trapezförmigen Stromkanal mit einer geometrischen Breite von wk = 0.6 µm und einer Länge von 1k = 0.2 µm. Die Isolationsbarrieren wurden durch eine selektive Implantation mit Bor-Ionen erzeugt und haben einen Isolationswiderstand von über $10^9$ Ω/sq(>$10^7$ Ωcm). Die Potentialbarrieren sind 0,4 µm breit. Die beobachtete cut-off Wellenlänge liegt bei ca. 1,1 µm. Die Messung wurde über einen Leistungsbereich von weniger als 1 nW bis 1 µW aufgenommen. Im Spannungsbereich unterhalb von ca. 2V beobachtet man ein ohmsches Verhalten des Kanalleitwerts. Mit zunehmender Lichtleistung reduziert sich der Kanalwiderstand. In dem vorteilhaften Bereich oberhalb ca. 2V zeigt sich ein typisches sättigendes Verhalten des Kanalstroms, der nicht mehr von der Betriebsspannung abhängt. Mit zunehmender Lichtleistung steigt der Kanalstrom empfindlich an.

In Fig. 12 sind die lichtleistungsabhängige Stromänderung und der Empfindlichkeitsverlauf über den gesamten gemessenen Bereich dargestellt. Die experimentellen Werte sind durch Punkte dargestellt. Eine rechnerische Anpassung nach den o.g. Gleichungen (1) bis (3) beschreibt das Verhalten sehr gut. Für die kleinsten Leistungen wurden Empfindlichkeiten von über $10^5$ A/W gemessen. Diese Leistungsdaten beziehen sich auf die gesamte ausgeleuchtete Mesafläche des Array-Detektors von 48x144 µm². Die Angaben sind also noch nicht bezüglich der reinen photoabsorbierenden Fläche korrigiert, die wesentlich geringer ist. Die interne Empfindlichkeit ist deshalb noch deutlich höher.

Insbesondere durch eine Miniaturisierung der Struktur hinsichtlich einer Vergrößerung des Füllfaktors und durch entsprechende Verkleinerung der Mesafläche, interner Parallelschaltung von Einzelelementen (siehe Fig. 10) und durch eine Optimierung der Kanalgeometrie sind noch deutlich höhere, extrinsische Detektorempfindlichkeiten zu erreichen.

**Patentansprüche**

**1.** Halbleiter-Photodetektor, mit einem zwei Anschlußpole (E, E') verbindenden Kanal (K) aus Halbleitermaterial, der durch Potentialbarrieren lateral und vertikal begrenzt ist und lateral an den Rändern mit Barrierebereichen (B, B') durch Raumladungszonen (R, R') eingeschränkt ist, wobei die Raumladungszonen (R, R') im lichtempfindlichen Bereich des Photodetektors liegen und diese durch einfallendes Licht reduzierbar sind dadurch gekennzeichnet,

- daß vertikal die Potentialbarriere durch eine Quantenwellstruktur ausgebildet ist.

**2.** Detektor nach Anspruch 1, dadurch gekennzeichnet, daß die die Quantenwellstruktur bildende Schichtenfolge aus einer auf ein semiisolierendes GaAs Substrat folgenden

- ersten Schicht (1') als Pufferschicht aus GaAs,

- zweiten Schicht (2) als Potentialtopfschicht aus InGaAs,
- dritten Schicht (3) als Deckschicht aus GaAs

gebildet ist.

3. Detektor nach Anspruch 1 oder 2, dadurch gekennzeichnet, daß die Barrierenbereiche (B, B') pn-Übergänge mit dem Kanalmaterial bilden.

4. Detektor nach Anspruch 1 oder 2, dadurch gekennzeichnet, daß die Barrierenbereiche (B, B') als isolierende Bereiche ausgeführt sind.

5. Detektor nach einem der Ansprüche 1 bis 4, dadurch gekennzeichnet, daß ein die Detektorstruktur tragendes Substrat transparent ist für das zu detektierende Licht.

6. Detektor nach einem der Ansprüche 1 bis 5, dadurch gekennzeichnet, daß der Kanal aus mehreren Teilkanälen besteht, die inselartig isolierte Barrierenbereiche umschließen.

7. Detektor nach einem der Ansprüche 1 bis 6, dadurch gekennzeichnet, daß die Barrierenbereiche eine trapezförmige Struktur aufweisen.

8. Detektor nach einem der Ansprüche 1 bis 7, gekennzeichnet durch seitlich des Kanals angeordnete Steuerelektroden zur Steuerung der Empfindlichkeit des Detektors.

9. Detektor nach einem der Ansprüche 1 bis 8, dadurch gekennzeichnet, daß der Kanal durch eine oder mehrere Potentialtopfschichten gebildet ist.

10. Detektor nach einem der Ansprüche 2 bis 9, gekennzeichnet durch Schaltungselemente, die an den Anschlußpolen (E,E') eine solche Spannung anlegen, daß eine Sättigung des Kanalstroms beim Betrieb des Detektors eintritt.

11. Detektor nach einem der Ansprüche 2 bis 10, gekennzeichnet durch seine mehrfache Anordnung in Form eines Zeilen- oder Flächenarrays.

12. Verfahren zur Herstellung eines Halbleiter-Photodetektors nach einem der vorhergehenden Ansprüche, dadurch gekennzeichnet, daß auf ein isolierendes Substrat die die Quantenwellstruktur bildende Schichtenfolge aufgebracht wird und senkrecht zur Schichtenfolge Potentialbarrierenbereiche zur lateralen Strukturierung des Stromkanals erzeugt werden.

13. Verfahren nach Anspruch 12, dadurch gekennzeichnet, daß die lateralen Potentialbarrieren (4) durch eine selektive Isolationsimplantation durch chemische indizierte Ladungsträgerkompensation ohne schädigungsinduzierte kristalldefekte mit Sauerstoffionen mittels Maskentechnik und anschließender Kurzzeitausleitung bei Temperaturen über 600$^o$C hergestellt werden.

14. Verfahren nach Anspruch 12, dadurch gekennzeichnet, daß die lateralen Potentialbarrieren (4) durch Isolationsgebiete gebildet werden, die durch eine schädigungsinduzierte, selektive Isolationsimplantation mittels Maskentechnik oder durch schädigungsinduzierte, fokussierte Ionenimplantation hergestellt werden.

15. Verfahren nach Anspruch 12, dadurch gekennzeichnet, daß die lateralen Potentialbarrieren (4) durch pn-Übergänge gebildet werden, die durch eine selektive Implantation mittels Maskentechnik oder eine durch fokussierte Implantation von Dotierionen mit dem jeweils anderen Ladungsträgertyp als in der leitfähigen Schicht (2, 5) und anschließender Trägeraktivierung durch Ausheilung hergestellt werden.

16. Verfahren nach Anspruch 12, dadurch gekennzeichnet, daß die lateralen Potentialbarrieren (4) durch Vakuumbereiche gebildet werden und durch eine selektive Grubenätzung mittels naßchemischer oder plasmachemischer Verfahren realisiert werden.

17. Verfahren nach einem der Ansprüche 12 bis 15, dadurch gekennzeichnet, daß vertikale Potentialbarrieren durch Einsatz von Heterostrukturen gebildet werden, die durch epitaktische Wachstumsverfahren hergestellt werden.

18. Verfahren zur Herstellung eines Halbleiter-Photodetektors nach Anspruch 1, dadurch gekennzeichnet, daß die Detektorstruktur dadurch erzeugt wird, daß Isolationsbereiche bzw. dotierte Bereiche des anderen Ladungsträgertyps als in den leitfähigen Schichten direkt in der Substratscheibe durch Einsatz von selektiven Implantationstechniken oder einen fokussierten Ionenstrahl hergestellt werden und anschließend die leitfähigen Schichten durch einen epitaktischen Überwachstumsprozeß realisiert werden.

19. Verfahren zur Herstellung eines Halbleiter-Photodetektors nach Anspruch 1, dadurch gekennzeichnet, daß die leitfähigen Schichten (2, 3) mit selektiven Implantationsverfahren durch Ionenbeschuß oder mit einem fokussierten Ionenstrahl innerhalb einer nichtleitenden Schicht hergestellt werden.

**Claims**

1. Semiconductor photodetector with a channel (K), which connects two terminal poles (E, E'), of semiconductor material, which is laterally and vertically bounded by potential barriers and which is laterally limited at the edges with barrier regions (B, B') by space-charge zones (R, R'), wherein the space-charge zones (R, R') lie in the light-sensitive region of the photodetector and these are reducible by incident light, characterised in that the potential barrier is formed vertically by a quantum wave structure.

2. Detector according to claim 1, characterised in that the layer sequence forming the quantum wave structure is formed by a first layer (1') as buffer layer of GaAs, second layer (2) as potential well layer of InGaAs and third layer (3) as cover layer of GaAs following on a semi-insulating GaAs substrate.

3. Detector according to claim 1 or 2, characterised in that the barrier regions (B, B') form pn transitions with the channel material.

4. Detector according to claim 1 or 2, characterised in that the barrier regions (B, B') are executed as insulating regions.

5. Detector according to one of claims 1 to 4, characterised in that a substrate carrying the detector structure is transparent to the light to be detected.

6. Detector according to one of claims 1 to 5, characterised in that the channel consists of several part channels, which surround island-like insulated barrier regions.

7. Detector according to one of claims 1 to 6, characterised in that the barrier regions have a trapezium-shaped structure.

8. Detector according to one of claims 1 to 7, characterised by control electrodes arranged laterally of the channel for control of the sensitivity of the detector.

9. Detector according to one of claims 1 to 8, characterised in that the channel is formed by one or more potential well layers.

10. Detector according to one of claims 2 to 9, characterised by circuit elements which apply such a voltage to the terminal poles (E, E') that a saturation of the channel current occurs during operation of the detector.

11. Detector according to one of claims 2 to 10, characterised by a multiple arrangement in the form of lineal arrays or areal arrays.

12. Method of producing a semiconductor photodetector according to one of the preceding claims, characterised in that the layer sequence forming the quantum wave structure is formed on an insulating substrate and potential barrier regions for lateral structuring of the flow channel are produced perpendicularly to the layer sequence.

13. Method according to claim 12, characterised in that the lateral potential barriers (4) are produced by a selective insulation implantation by chemically indicated charge carrier compensation without damage-induced crystal defects with oxygen ions by means of a mask technique and subsequent temporary conducting out at temperatures above 600°C.

14. Method according to claim 12, characterised in that the lateral potential barriers (4) are formed by insulation regions, which are produced by a damage-induced selective insulation implantation by means of a mask technique or by damage-induced focussed ion implantation.

15. Method according to claim 12, characterised in that the lateral potential barriers (4) are formed by pn transitions, which are produced by a selective implantation by means of a mask technique or a focussed implantation of doping ions with the respective charge carrier type other than in the conductive layer (2, 5) and subsequent carrier activation by curing.

16. Method according to claim 12, characterised in that the lateral potential barriers (4) are formed by vacuum regions and realised by a selective trench etching by means of wet-chemical or plasma-chemical methods.

17. Method according to one of claims 12 to 15, characterised in that vertical potential barriers are formed by use of heterostructures, which are produced by an epitaxial growth method.

18. Method of producing a semiconductor photodetector according to claim 1, characterised in that the detector structure is produced thereby that the insulation regions or doped regions of the charge carrier type other than in the conductive layers are produced directly in the substrate wafer by use of selective implantation techniques or a focussed ion beam and subsequently the conductive layers are realised by an epitaxial overgrowth technique.

19. Method of producing a semiconductor photodetector according to claim 1, characterised in that the conductive layers (2, 3) are produced with a selective implantation process by ion bombardment or with a focussed ion beam within a non-conductive layer.

**Revendications**

1. Photodétecteur à semiconducteurs comportant un canal (K) reliant deux pôles de connexion (E,E') et réalisé en un matériau semiconducteur, et qui est limité latéralement et verticalement par des barrières de potentiel et est confiné latéralement, au niveau des bords avec des zones formant barrières (B,B') par des zones de charges d'espace (R,R'), les zones de charge d'espace (R,R') étant situées dans la zone photosensible du photodétecteur et ces zones pouvant être réduites par une lumière incidente, caractérisé en ce

   - que les barrières potentielles sont formées verticalement par une structure de puits quantique.

2. Détecteur selon la revendication 1, caractérisé en ce que la succession de couches, qui constitue la structure de puits quantique est constituée par

   - une première couche (1') agissant en tant que couche tampon GaAs,
   - une seconde couche (2) agissant en tant que couche de puits de potentiel en InGaAs,
   - Une troisième couche (3) agissant en tant que couche de revêtement en GaAs,

   qui se succèdent sur un substrat en GaAs semi-isolant.

3. Détecteur selon la revendication 1 ou 2, caractérisé en ce que les zones formant barrières (B,B') forment des jonctions pn avec le matériau du canal.

4. Détecteur selon la revendication 1 ou 2, caractérisé en ce que les zones formant barrières (B,B') sont réalisées sous la forme de zones isolantes.

5. Détecteur selon l'une des revendications 1 à 4, caractérisé en ce qu'un substrat portant la structure du détecteur est transparent pour la lumière à détecter.

6. Détecteur selon l'une des revendications 1 à 5, caractérisé en ce que le canal est formé de plusieurs canaux partiels, qui entourent des zones formant barrières isolées à la manière d'îlots.

7. Détecteur selon l'une des revendications 1 à 6, caractérisé en ce que les zones formant barrières possèdent une structure de forme trapézoïdale.

8. Détecteur selon l'une des revendications 1 à 7, caractérisé par des électrodes de commande disposées latéralement par rapport au canal pour la commande de la sensibilité du détecteur.

9. Détecteur selon l'une des revendications 1 à 8, caractérisé en ce que le canal est formé par une ou plusieurs couches de puits de potentiel.

10. Détecteur selon l'une des revendications 2 à 9, caractérisé par des éléments de circuit, qui appliquent aux pôles de connexion (E,E') une tension telle qu'une saturation du courant du canal apparaît lors du fonctionnement du détecteur.

11. Détecteur selon l'une des revendications 2 à 10, caractérisé par sa disposition multiple sous la forme d'un réseau de lignes ou de surfaces.

12. Procédé pour fabriquer un photodétecteur à semiconducteurs selon l'une des revendications précédentes, caractérisé en ce qu'on dépose la succession de couches formant la structure de puits quantique sur un substrat isolant et que l'on forme, perpendiculairement à la succession de couches, des zones formant barrières de potentiel pour la structuration latérale du canal de courant.

13. Procédé selon la revendication 12, caractérisé en ce que les barrières latérales de potentiel (4) sont formées au moyen d'une implantation sélective d'isolation à l'aide d'une compensation chimique indicée de porteurs de charges sans défaut cristallin induit par des endommagements, avec des ions oxygène en utilisant une technique à masques et un recuit ultérieur de distribution de brève durée à des températures dépassant 600°C.

14. Procédé selon la revendication 12, caractérisé en ce que les barrières latérales de potentiel (4) sont formées par des zones d'isolation, qui sont fabriquées au moyen d'une implantation sélective d'isolation, induite par endommagement, à l'aide d'une technique à masques ou au moyen d'une implantation focalisée d'ions, induite par endommagement.

15. Procédé selon la revendication 12, caractérisé en ce que les barrières latérales de potentiel (4) sont formées par des jonctions pn, qui sont réalisées au moyen d'une implantation sélective à l'aide d'une technique à masques ou à l'aide d'une implantation focalisée d'ions dopants ayant le type de porteurs de charges qui est opposé à celui présent dans la couche conductrice (2,5) et par activation ultérieure des porteurs au moyen d'un recuit de distribution.

**16.** Procédé selon la revendication 12, caractérisé en ce que les barrières latérales de potentiel (4) sont formées au moyen de zones à dépression et sont réalisées au moyen d'une corrosion sélective de sillons à l'aide de procédés par voie chimique humide ou de procédés de la chimie des plasmas.

**17.** Procédé selon l'une des revendications 12 à 15, caractérisé en ce que les barrières verticales de potentiel sont formées par l'utilisation d'hétérostructures, qui sont réalisées à l'aide de procédés de croissance épitaxiale.

**18.** Procédé pour fabriquer un photodétecteur à semiconducteurs selon la revendication 1, caractérisé en ce que la structure du détecteur est obtenue par le fait qu'on forme des régions isolantes ou des régions dopées possédant l'autre type de porteurs de charges, qui diffère du type des porteurs de charges présents dans les couches conductrices, directement dans la pastille du substrat par utilisation de techniques d'implantation sélectives ou d'un faisceau focalisé d'ions, et qu'ensuite on forme les couches conductrices en utilisant un procédé de surcroissance épitaxiale.

**19.** Procédé pour fabriquer un photodétecteur à semiconducteur selon la revendication 1, caractérisé en ce qu'on fabrique les couches conductrices (2,3) au moyen d'un procédé d'implantation sélective, au moyen d'une projection d'ions ou au moyen d'un faisceau focalisé d'ions à l'intérieur d'une couche non conductrice.

Fig.1

Fig. 2

Fig. 3

Fig. 4

A

3

2

1'

1

A'

Fig. 5

Fig. 6

Fig. 7

4 | 5 | 4

im Dunkeln

unter Beleuchtung

$E_{cb}$

$E_F$

$E_{vb}$

Fig. 8

Fig. 9

a)

b)

c)

Fig. 10

FIG. 11

FIG. 12